# EUROPEAN PATENT SPECIFICATION

(11) **EP 3 104 009 B1**
(45) Date of publication and mention of the grant of the patent: **19.09.2018**
(21) Application number: 16151592.9
(22) Date of filing: 15.01.2016
(51) Int. Cl.: F04B 23/02, H01L 23/473, F04B 11/00

(54) **LIQUID SUPPLY MECHANISM AND LIQUID COOLING SYSTEM**
FLÜSSIGKEITSZUFÜHRMECHANISMUS UND FLÜSSIGKEITSKÜHLSYSTEM
MÉCANISME D'ALIMENTATION EN LIQUIDE ET SYSTÈME DE REFROIDISSEMENT DE LIQUIDE

(30) Priority: 12.05.2015 CN 201520303586 U; 22.05.2015 CN 201510266823
(43) Date of publication of application: 14.12.2016
(73) Proprietor: Cooler Master Co., Ltd., New Taipei City, 235 (TW)
(72) Inventor: Liao, Pen-Hung, 235 New Taipei City (TW); Huang, Shih-Wei, 235 New Taipei City (TW)
(74) Representative: Becker Kurig Straus

(56) References cited:
- DE-A1-102011 120 895
- DE-B- 1 169 738
- DE-B- 1 188 247
- DE-C- 94 429
- FR-A- 1 181 593
- US-A- 3 907 001
- US-A1- 2005 173 097

## Description

### Field of the Invention

The present invention relates to a liquid supply mechanism and a liquid cooling system, particularly a liquid supply mechanism capable of preventing a liquid cooling system from generating high hydraulic pressure while supplying a cooling liquid to the liquid cooling system.

### Background of the Invention

In general, a liquid cooling system essentially consists of a liquid cooling head, a radiator, a pump and a liquid storage box connected through a plurality of tubes. When the liquid cooling system is dissipating heat from an electronic component, the pump transports a cooling liquid to the liquid cooling head, the cooling liquid absorbs the heat generated by the electronic component, and then the radiator cools the cooling liquid. After the liquid cooling system is used for a long time, the cooling liquid will reduce due to vaporization, such that the cooling liquid may be insufficient. If the user does not supply the cooling liquid in time, the liquid cooling system may be damaged due to insufficient cooling liquid.

Furthermore, the related art US Patent No. 3,907,001 (hereinafter '001 art) provides a combination accumulator reservoir device in a single package. In '001 art, there is only one O-ring seal disposed on the main body portion of the piston. Since the main body portion of the piston can only move within the chamber, the O-ring seal always abuts against the wall of the chamber no matter how the height of the piston changes. In other words, the number of the O-ring seal does not and cannot change in response to the height of the piston. Moreover, the related art US Patent Publication No. 2005/0173097 (hereinafter '097 art) provides a liquid circulation type cooling system including a circulating pump for circulating a liquid and a heat exchanger disposed in a heat radiation space and for radiating heat outside the system. In '097 art, there is no damping member or the like disposed in the liquid reservoir of the heat exchanger.

### Summary of the Invention

The present invention aims at providing a liquid supply mechanism and a liquid cooling system equipped with the liquid supply mechanism, thereby resolving the aforesaid problems.

This is achieved by a liquid supply mechanism according to claim 1 and a liquid cooling system according to claim 6. The dependent claims pertain to corresponding further developments and improvements.

As will be seen more clearly from the detailed description following below, the claimed liquid supply mechanism includes a lower cover, an upper cover, a plunger, a driving unit and at least one damping member. The lower cover has a liquid outlet and the upper cover is connected to the lower cover. A chamber is formed between the lower cover and the upper cover. The chamber communicates with the liquid outlet. The upper cover has an axial hole. The plunger is movably disposed in the chamber. The plunger has an axial rod and the axial rod is inserted into the axial hole. The driving unit is disposed in the chamber and the driving unit drives the plunger to move. The damping member is disposed on the axial rod and abuts against an inner wall of the axial hole.

As will be seen more clearly from the detailed description following below, the claimed liquid cooling system includes a liquid cooling head, a radiator, a pump, a liquid storage box, a plurality of tubes and a liquid supply mechanism. The tubes are connected between the liquid cooling head, the radiator, the pump and the liquid storage box. The liquid supply mechanism is selectively connected to one of the liquid cooling head, the radiator, the pump, the liquid storage box and the tubes. The liquid supply mechanism includes a lower cover, an upper cover, a plunger, a driving unit and at least one damping member. The lower cover has a liquid outlet and the upper cover is connected to the lower cover. A chamber is formed between the lower cover and the upper cover. The chamber communicates with the liquid outlet. The upper cover has an axial hole. The plunger is movably disposed in the chamber. The plunger has an axial rod and the axial rod is inserted into the axial hole. The driving unit is disposed in the chamber and the driving unit drives the plunger to move. The damping member is disposed on the axial rod and abuts against an inner wall of the axial hole.

### Brief Description of the Drawings

In the following, the invention is further illustrated by way of example, taking reference to the accompanying drawings thereof:
FIG. 1 is a schematic view illustrating a liquid cooling system according to an embodiment of the invention,
FIG. 2 is a schematic view illustrating a liquid supply mechanism connected to a pump 14,
FIG. 3 is an exploded view illustrating the liquid supply mechanism,
FIG. 4 is a cross-sectional view illustrating the liquid supply mechanism and the pump,
FIG. 5 is a cross-sectional view illustrating the plunger shown in FIG. 4 after being pushed by the resilient member,
FIG. 6 is a cross-sectional view illustrating a liquid supply mechanism according to another embodiment of the invention,
FIG. 7 is a cross-sectional view illustrating the liquid supply mechanism and the radiator according to another embodiment of the invention,
FIG. 8 is a cross-sectional view illustrating a liquid supply mechanism according to another embodiment of the invention, and
FIG. 9 is a cross-sectional view illustrating a liquid supply mechanism according to another embodiment of the invention.

### Detailed Description

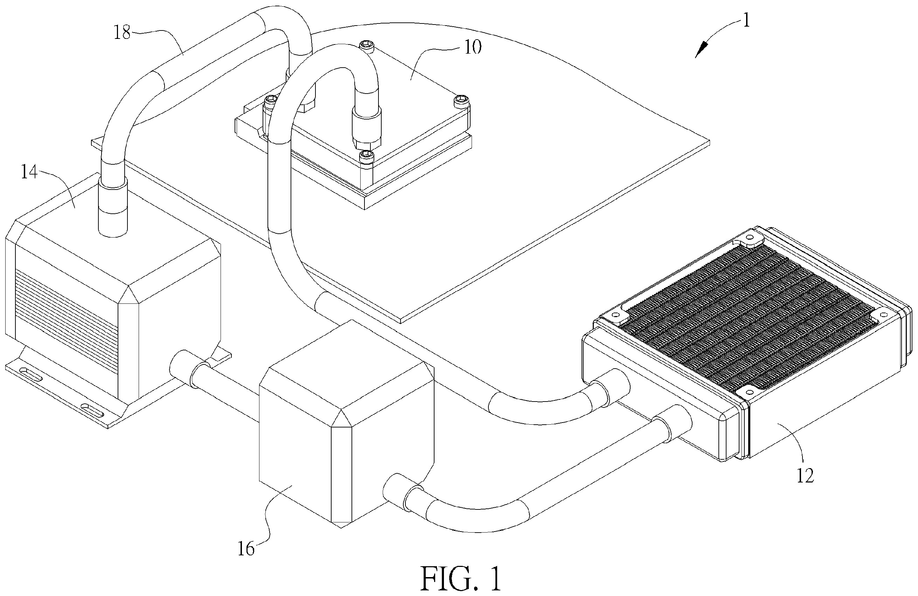

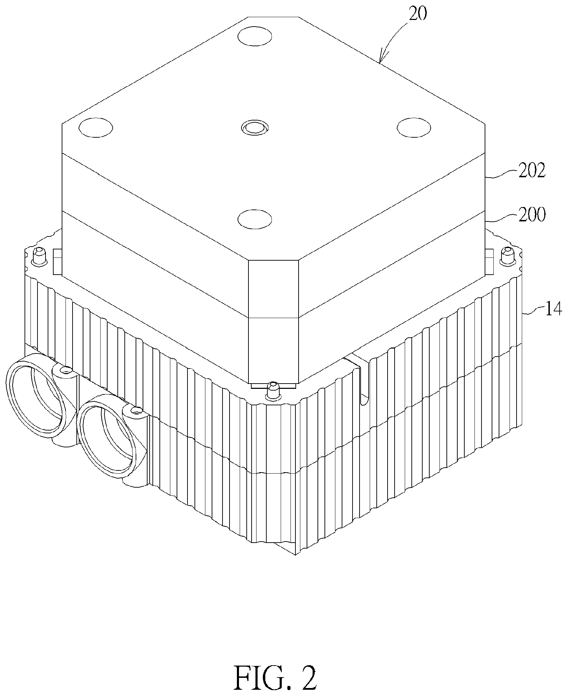

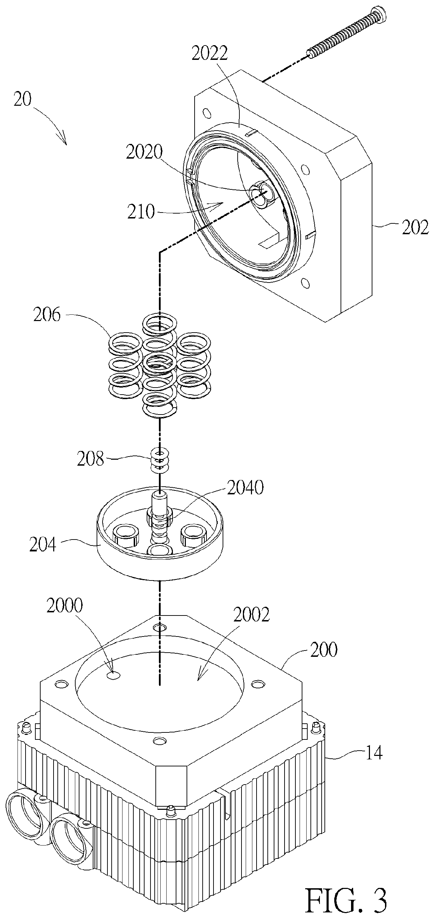

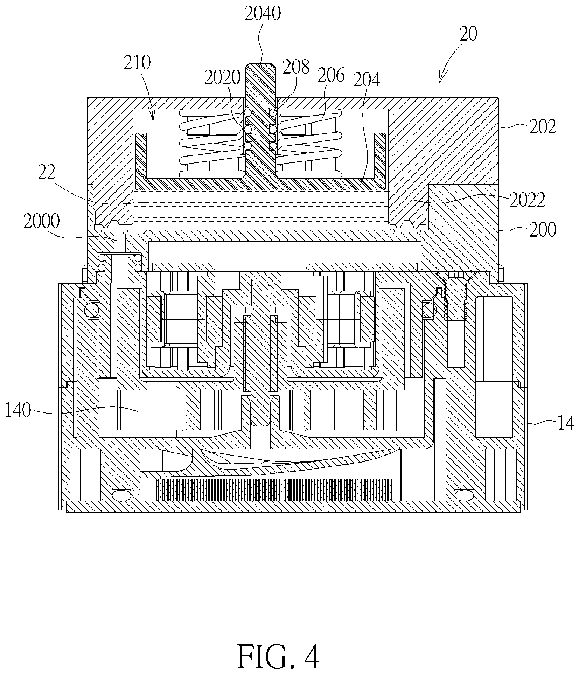

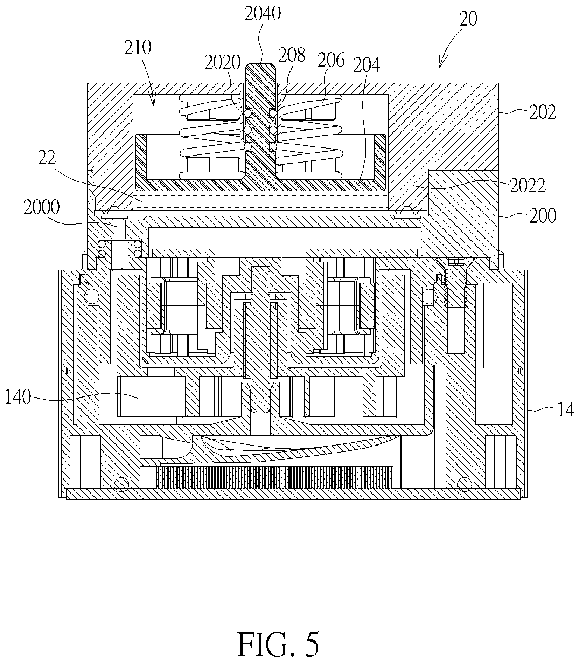

Referring to FIGs. 1 to 5, FIG. 1 is a schematic view illustrating a liquid cooling system 1 according to an embodiment of the invention, FIG. 2 is a schematic view illustrating a liquid supply mechanism 20 connected to a pump 14, FIG. 3 is an exploded view illustrating the liquid supply mechanism 20, FIG. 4 is a cross-sectional view illustrating the liquid supply mechanism 20 and the pump 14, and FIG. 5 is a cross-sectional view illustrating the plunger 204 shown in FIG. 4 after being pushed by the driving unit 206.

As shown in FIG. 1, the liquid cooling system 1 includes a liquid cooling head 10, a radiator 12, a pump 14, a liquid storage box 16 and a plurality of tubes 18. The tubes 18 are connected between the liquid cooling head 10, the radiator 12, the pump 14 and the liquid storage box 16 and used for transporting a cooling liquid between the liquid cooling head 10, the radiator 12, the pump 14 and the liquid storage box 16. The cooling liquid (not shown in FIG. 1) is filled in the liquid cooling head 10, the radiator 12, the pump 14, the liquid storage box 16 and the tubes 18. When the liquid cooling system 1 of the invention is used for dissipating heat from an electronic component (not shown), the liquid cooling head 10 of the liquid cooling system 1 is attached on the electronic component. The pump 14 transports the cooling liquid to the liquid cooling head 10, the cooling liquid absorbs the heat generated by the electronic component, and then the radiator 12 cools the cooling liquid. In practical applications, the cooling liquid may be water or other liquids.

As shown in FIGs. 2 to 5, the liquid cooling system 1 further includes a liquid supply mechanism 20 connected to the pump 14. It should be noted that the liquid supply mechanism 20 is not limited to be connected to the pump 14. In another embodiment, the liquid supply mechanism 20 may also be connected to the liquid cooling head 10, the radiator 12, the liquid storage box 16 or the tube 18. In other words, the liquid supply mechanism 20 of the invention may be selectively connected to one of the liquid cooling head 10, the radiator 12, the pump 14, the liquid storage box 16 and the tubes 18 according to practical applications.

The liquid supply mechanism 20 includes a lower cover 200, an upper cover 202, a plunger 204, a driving unit 206 and at least one damping member 208. The lower cover 200 has a liquid outlet 2000. The upper cover 202 is connected to the lower cover 200 and a chamber 210 is formed between the lower cover 200 and the upper cover 202. The chamber 210 communicates with the liquid outlet 2000 and contains a cooling liquid 22. The upper cover 202 has an axial hole 2020, wherein the axial hole 2020 is pillar-shaped. In this embodiment, the lower cover 200 has a connecting hole 2002 and the upper cover 202 has a ring-shaped wall 2022 surrounding the chamber 210, wherein the liquid outlet 2000 is located within the connecting hole 2002. When the upper cover 202 is connected to the lower cover 200, the ring-shaped wall 2022 of the upper cover 202 is connected to the connecting hole 2002 of the lower cover 200 tightly.

The plunger 204 is movably disposed in the chamber 210. The plunger 204 has an axial rod 2040 and the axial rod 2040 is inserted into the axial hole 2020. The driving unit 206 is disposed in the chamber 210 and the driving unit 206 is used for driving the plunger 204 to move. In this embodiment, the driving unit 206 may be a resilient member (e.g. spring or other resilient objects) and opposite ends of the driving unit 206 abut against the upper cover 202 and the plunger 204. The damping member 208 is disposed on the axial rod 2040 and abuts against an inner wall of the axial hole 2020. In this embodiment, the damping member 208 may be, but not limited to, an O-ring. Furthermore, the number of the driving units 206 and the damping members 208 may be determined according to practical applications, so they are not limited to the embodiment shown in the figures.

In this embodiment, the lower cover 200 of the liquid supply mechanism 20 is connected to the pump 14, such that the liquid outlet 2000 communicates with the pump 14. The liquid outlet 2000 of the lower cover 200 is corresponding to a liquid inlet 140 of the pump 14 (as shown in FIGs. 4 and 5), such that the cooling liquid 22 within the chamber 210 can be injected into the pump 14 through the liquid outlet 2000 and the liquid inlet 140.

As shown in FIG. 4, when the liquid supply mechanism 20 is assembled completely and the chamber 210 contains the cooling liquid 22, the driving unit 206 is compressed. At this time, the driving unit 206 pushes the plunger 204 to move downward in the chamber 210 till the hydraulic pressure of the pump 14 balances. When the cooling liquid of the pump 14 reduces and then the hydraulic pressure reduces, the driving unit 206 of the liquid supply mechanism 20 will push the plunger 204 to move, so as to inject the cooling liquid 22 from the chamber 210 into the pump 14. In other words, the liquid supply mechanism 20 of the invention can supply the cooling liquid to the liquid cooling system 1 automatically when the cooling liquid is insufficient, so as to prevent the liquid cooling system 1 from being damaged due to insufficient cooling liquid. It should be noted that in addition to using the driving unit 206 to generate elastic force to push the plunger 204 to move, the invention may also replace the driving unit 206 by other mechanisms, which may generate normal force, shearing force, torque or magnetic force, to push the plunger 204 to move, so as to supply the cooling liquid.

Still further, the damping member 208 is disposed on the axial rod 2040 of the plunger 204 and abuts against an inner wall of the axial hole 2020 of the upper cover 202. When the plunger 204 is moving, a damping effect is generated between the damping member 208 and the inner wall of the axial hole 2020, so as to reduce the push force generated by the driving unit 206 for the plunger 204. As shown in FIG. 4, when the chamber 210 contains more cooling liquid 22, the driving unit 206 has larger amount of compression and more damping members 208 abut against the inner wall of the axial hole 2020. In other words, when the chamber 210 contains more cooling liquid 22, the push force generated by the driving unit 206 for the plunger 204 is larger and the invention uses more damping members 208 to provide larger damping effect, so as to reduce the push force generated by the driving unit 206 for the plunger 204. As shown in FIG. 5, when the chamber 210 contains less cooling liquid 22, the height of the plunger 204 reduces, the driving unit 206 has smaller amount of compression, and the number of damping members 208 abutting against the inner wall of the axial hole 2020 decrease. In other words, when the chamber 210 contains less cooling liquid 22, the push force generated by the driving unit 206 for the plunger 204 reduces and the invention uses less damping members 208 to provide smaller damping effect, so as to reduce the push force generated by the driving unit 206 for the plunger 204. Accordingly, the invention can adjust the damping effect according to the amount of the cooling liquid 22 within the chamber 210, so as to prevent the liquid cooling system 1 from generating high hydraulic pressure while supplying the cooling liquid to the liquid cooling system 1, such that the heat dissipating efficiency of the liquid cooling system 1 will not be affected.

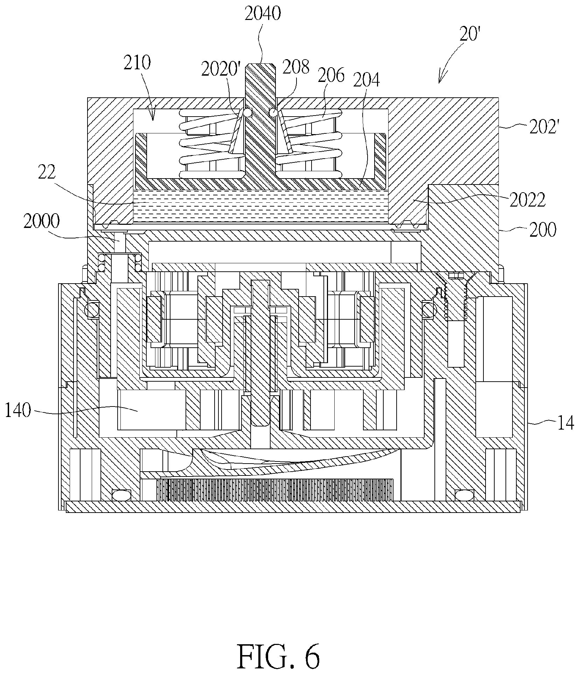

Referring to FIG. 6, FIG. 6 is a cross-sectional view illustrating a liquid supply mechanism 20' according to another embodiment of the invention. The difference between the liquid supply mechanism 20' and the liquid supply mechanism 20 is that the axial hole 2020' of the upper cover 202' of the liquid supply mechanism 20' is taper-shaped and the liquid supply mechanism 20' has one single damping member 208, as shown in FIG. 6. When the driving unit 206 pushes the plunger 204 to move downward, the contact force between the damping member 208 and the inner wall of the axial hole 2020' will reduce since the axial hole 2020' is taper-shaped. Accordingly, the invention can adjust the damping effect according to the amount of the cooling liquid 22 within the chamber 210. It should be noted that the same elements in FIG. 6 and FIG. 4 are represented by the same numerals, so the repeated explanation will not be depicted herein again.

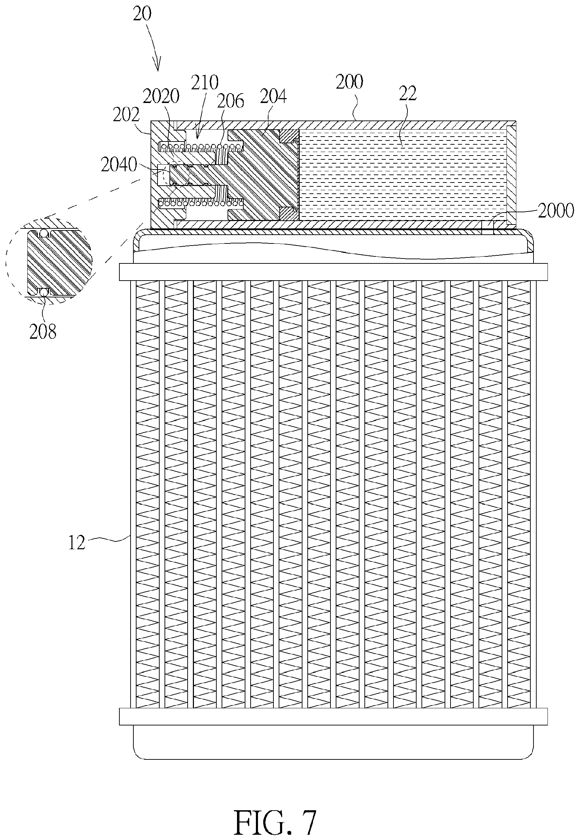

Referring to FIG. 7, FIG. 7 is a cross-sectional view illustrating the liquid supply mechanism 20 and the radiator 12 according to another embodiment of the invention. As shown in FIG. 7, the liquid supply mechanism 20 may be connected to the radiator 12, such that the liquid outlet 2000 communicates with the radiator 12. Accordingly, when the cooling liquid of the radiator 12 reduces and then the hydraulic pressure reduces, the driving unit 206 of the liquid supply mechanism 20 will push the plunger 204 to move, so as to inject the cooling liquid 22 from the chamber 210 into the radiator 12. It should be noted that the same elements in FIG. 7 and FIG. 4 are represented by the same numerals, so the repeated explanation will not be depicted herein again.

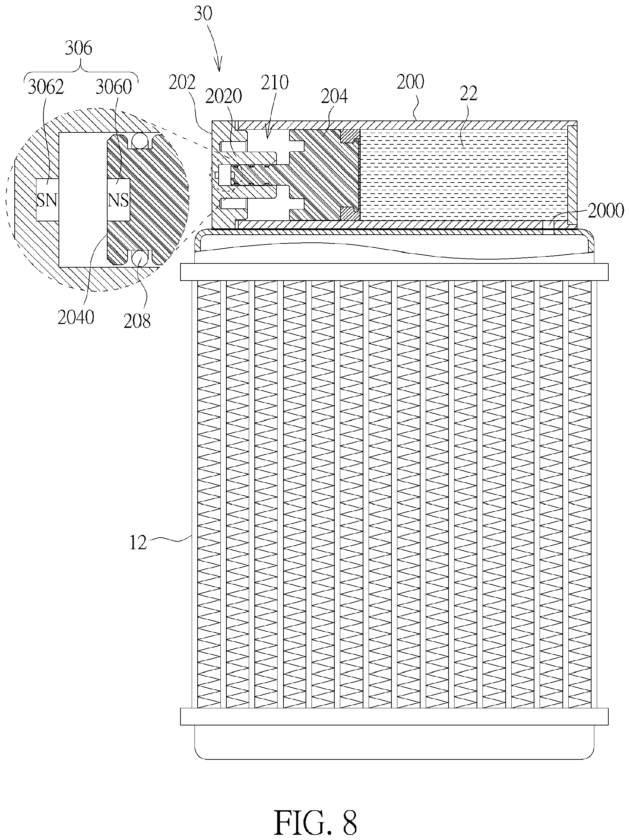

Referring to FIG. 8, FIG. 8 is a cross-sectional view illustrating a liquid supply mechanism 30 according to another embodiment of the invention. The difference between the liquid supply mechanism 30 and the aforesaid liquid supply mechanism 20 is that the liquid supply mechanism 30 replaces the aforesaid driving unit 206 by a driving unit 306. As shown in FIG. 8, the driving unit 306 includes a first magnetic area 3060 and a second magnetic area 3062. The first magnetic area 3060 is disposed on the upper cover 202 and the second magnetic area 3062 is disposed on the plunger 204, wherein a position of the first magnetic area 3060 is corresponding to a position of the second magnetic area 3062. A magnetic pole of an end of the first magnetic area 3060 facing the second magnetic area 3062 is identical to a magnetic pole of an end of the second magnetic area 3062 facing the first magnetic area 3060, such that a magnetic repulsive force is generated between the first magnetic area 3060 and the second magnetic area 3062. It should be noted that the magnetic pole of an end of the first magnetic area 3060 facing the second magnetic area 3062 and the magnetic pole of an end of the second magnetic area 3062 facing the first magnetic area 3060 both may be north magnetic poles or south magnetic poles according to practical applications. In this embodiment, the first magnetic area 3060 may be a magnet or an electromagnet, and the second magnetic area 3062 may be a magnet. It should be noted that the same elements in FIG. 8 and FIG. 7 are represented by the same numerals, so the repeated explanation will not be depicted herein again.

When the liquid supply mechanism 30 is assembled completely and the chamber 210 contains the cooling liquid 22, the magnetic repulsive force generated between the first magnetic area 3060 and the second magnetic area 3062 balances with the hydraulic pressure generated by the cooling liquid 22. Meanwhile, the plunger 204 stays static in the chamber 210. When the cooling liquid of the radiator 12 reduces and then the hydraulic pressure reduces, the magnetic repulsive force generated between the first magnetic area 3060 and the second magnetic area 3062 will push the plunger 204 to move, so as to inject the cooling liquid 22 from the chamber 210 into the radiator 12. When the magnetic repulsive force generated between the first magnetic area 3060 and the second magnetic area 3062 balances with the hydraulic pressure generated by the cooling liquid 22 again, the plunger 204 stops moving.

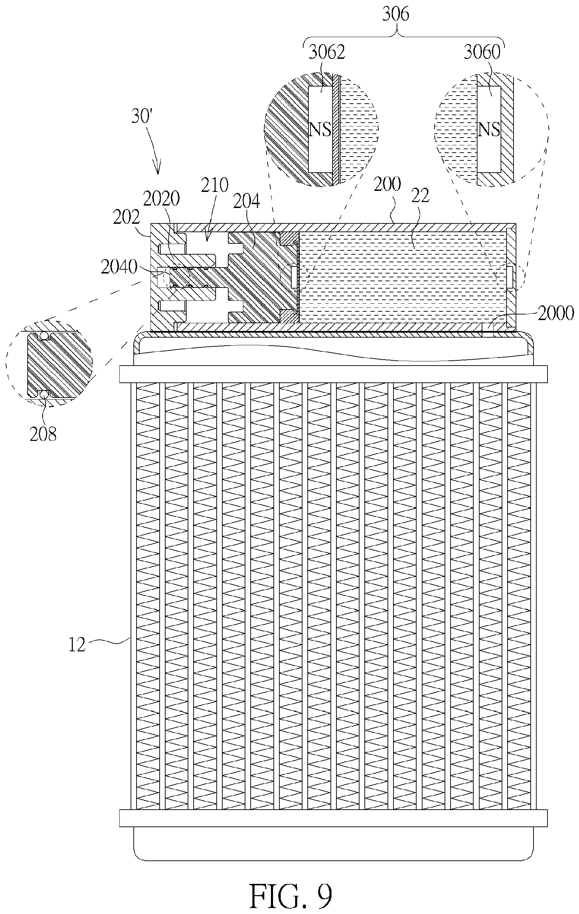

Referring to FIG. 9, FIG. 9 is a cross-sectional view illustrating a liquid supply mechanism 30' according to another embodiment of the invention. The difference between the liquid supply mechanism 30' and the aforesaid liquid supply mechanism 30 is that the first magnetic area 3060 is disposed on the lower cover 200 and the second magnetic area 3062 is disposed on the plunger 204, as shown in FIG. 9. A position of the first magnetic area 3060 is corresponding to a position of the second magnetic area 3062. In this embodiment, a magnetic pole of an end of the first magnetic area 3060 facing the second magnetic area 3062 is opposite to a magnetic pole of an end of the second magnetic area 3062 facing the first magnetic area 3060, such that a magnetic attraction force is generated between the first magnetic area 3060 and the second magnetic area 3062. It should be noted that the magnetic pole of an end of the first magnetic area 3060 facing the second magnetic area 3062 may be a north magnetic pole or a south magnetic pole, and the magnetic pole of an end of the second magnetic area 3062 facing the first magnetic area 3060 may be a south magnetic pole or a north magnetic pole correspondingly according to practical applications. In this embodiment, the first magnetic area 3060 may be a magnetic induction material (e.g. iron or other metals), a magnet or an electromagnet, and the second magnetic area 3062 may be a magnet.

When the liquid supply mechanism 30' is assembled completely and the chamber 210 contains the cooling liquid 22, the magnetic attraction force generated between the first magnetic area 3060 and the second magnetic area 3062 balances with the hydraulic pressure generated by the cooling liquid 22. Meanwhile, the plunger 204 stays static in the chamber 210. When the cooling liquid of the radiator 12 reduces and then the hydraulic pressure reduces, the magnetic attraction force generated between the first magnetic area 3060 and the second magnetic area 3062 will pull the plunger 204 to move, so as to inject the cooling liquid 22 from the chamber 210 into the radiator 12. When the magnetic attraction force generated between the first magnetic area 3060 and the second magnetic area 3062 balances with the hydraulic pressure generated by the cooling liquid 22 again, the plunger 204 stops moving.

In this embodiment, the first magnetic area 3060 may be detachably disposed on a bottom of the lower cover 200. When a user wants to supply the cooling liquid 22 to the liquid supply mechanism 30', the user may detach the first magnetic area 3060 from the bottom of the lower cover 200 first, so as to prevent the magnetic attraction force generated between the first magnetic area 3060 and the second magnetic area 3062 from hindering the supply of the cooling liquid 22.

As mentioned in the above, the liquid supply mechanism of the invention is selectively connected to one of the liquid cooling head, the radiator, the pump, the liquid storage box and the tubes. When the cooling liquid reduces and then the hydraulic pressure of the liquid cooling system reduces, the driving unit of the liquid supply mechanism will push the plunger to move, so as to inject the cooling liquid from the chamber into the liquid cooling system. In other words, the liquid supply mechanism of the invention can supply the cooling liquid to the liquid cooling system automatically when the cooling liquid is insufficient, so as to prevent the liquid cooling system from being damaged due to insufficient cooling liquid. Furthermore, the damping member is disposed on the axial rod of the plunger and abuts against the inner wall of the axial hole. When the plunger is moving, a damping effect is generated between the damping member and the inner wall of the axial hole, so as to reduce the push force generated by the driving unit for the plunger. Accordingly, the invention can prevent the liquid cooling system from generating high hydraulic pressure while supplying the cooling liquid to the liquid cooling system, such that the heat dissipating efficiency of the liquid cooling system will not be affected.

## Claims

1. A liquid supply mechanism (20, 20', 30, 30') comprising:
a lower cover (200) having a liquid outlet (2000);
an upper cover (202, 202') connected to the lower cover (200), a chamber (210) being formed between the lower cover (200) and the upper cover (202, 202'), the chamber (210) communicating with the liquid outlet (2000), the upper cover (202, 202') having an axial hole (2020, 2020');
a plunger (204) movably disposed in the chamber (210), the plunger (204) having an axial rod (2040), the axial rod (2040) being inserted into the axial hole (2020, 2020');
a driving unit (206, 306) disposed in the chamber (210), the driving unit (206, 306) driving the plunger (204) to move; and
**characterized by** the liquid supply mechanism (20, 20', 30, 30') further comprising:
a plurality of damping members (208) disposed on the axial rod (2040), wherein a number of the damping members abutting against an inner wall of the axial hole (2020, 2020') changes in response to a height of the plunger.

2. The liquid supply mechanism (20, 20', 30, 30') of claim 1 further **characterized in that** the damping member (208) is an O-ring.

3. The liquid supply mechanism (20, 20', 30, 30') of claim 1 further **characterized in that** the axial hole (2020, 2020') is pillar-shaped or taper-shaped.

4. The liquid supply mechanism (20, 20') of claim 1 further **characterized in that** the lower cover (200) has a connecting hole (2002), the upper cover (202, 202') has a ring-shaped wall surrounding the chamber (210), and the ring-shaped wall is connected to the connecting hole (2002) tightly.

5. The liquid supply mechanism (20, 20') of claim 4 further **characterized in that** the liquid outlet (2000) is located within the connecting hole (2002).

6. The liquid supply mechanism (20, 20') of claim 1 further **characterized in that** the driving unit (206) is a resilient member and opposite ends of the driving unit (206) abut against the upper cover (202, 202') and the plunger (204).

7. The liquid supply mechanism (30) of claim 1 further **characterized in that** the driving unit (306) comprises a first magnetic area (3060) and a second magnetic area (3062), the first magnetic area (3060) is disposed on the upper cover (202), the second magnetic area (3062) is disposed on the plunger (204), a position of the first magnetic area (3060) is corresponding to a position of the second magnetic area (3062), and a magnetic pole of an end of the first magnetic area (3060) facing the second magnetic area (3062) is identical to a magnetic pole of an end of the second magnetic area (3062) facing the first magnetic area (3060), such that a magnetic repulsive force is generated between the first magnetic area (3060) and the second magnetic area (3062).

8. The liquid supply mechanism (30') of claim 1 further **characterized in that** the driving unit (306) comprises a first magnetic area (3060) and a second magnetic area (3062), the first magnetic area (3060) is disposed on the lower cover (200), the second magnetic area (3062) is disposed on the plunger (204), a position of the first magnetic area (3060) is corresponding to a position of the second magnetic area (3062), and a magnetic pole of an end of the first magnetic area (3060) facing the second magnetic area (3062) is opposite to a magnetic pole of an end of the second magnetic area (3062) facing the first magnetic area (3060), such that a magnetic attraction force is generated between the first magnetic area (3060) and the second magnetic area (3062).

9. A liquid cooling system (1) **characterized by** the liquid cooling system (1) comprising:
a liquid cooling head (10);
a radiator (12);
a pump (14);
a liquid storage box (16);
a plurality of tubes (18) connected between the liquid cooling head (10), the radiator (12), the pump (14) and the liquid storage box (16); and
the liquid supply mechanism (20, 20', 30, 30') of claim 1 selectively connected to one of the liquid cooling head (10), the radiator (12), the pump (14), the liquid storage box (16) and the tubes (18).

## Patentansprüche

1. Flüssigkeitsversorgungsmechanisums (20, 20', 30, 30') welcher umfasst:
eine untere Abdeckung (200) mit einem Flüssigkeits-Auslass (2000);
eine obere Abdeckung (202, 202'), die mit der unteren Abdeckung (200) verbunden ist, eine Kammer (210), die zwischen der unteren Abdeckung (200) und der oberen Abdeckung (202, 202') ausgebildet ist, worin die Kammer (210) mit dem Flüssigkeits-Auslass (2000) in Verbindung steht, worin die obere Abdeckung (202, 202') ein Axialloch (2020, 2020') aufweist;
einen Kolben (204), der in der Kammer (210) beweglich angeordnet ist, worin der Kolben (204) einen axial angeordneten Stab (2040) umfasst, worin der axial angeordnete Stab (2040) in das Axialloch (2020, 2020') insertiert ist;
eine Antriebseinheit (206, 306), die in der Kammer (210), vorgesehen ist, worin die Antriebseinheit (206, 306) den Kolben (204) zur Bewegung antreibt; und
**dadurch gekennzeichnet, dass** der Flüssigkeitsversorgungsmechanismus (20, 20', 30, 30') weiter umfasst:
mehrere Dämpfungselemente (208), die an dem axial angeordneten Stab (2040) vorgesehen sind, worin sich die Anzahl der Dämpfungselemente, die gegen eine Innenwand des Axiallochs (2020, 2020') anliegen, in Antwort auf die Höhe des Kolbens ändert.

2. Flüssigkeitsversorgungsmechanismus (20, 20', 30, 30') nach Anspruch 1 weiter **dadurch gekennzeichnet, dass** das Dämpfungselement (208) ein O-Ring ist.

3. Flüssigkeitsversorgungsmechanismus (20, 20', 30, 30') nach Anspruch 1 weiter **dadurch gekennzeichnet, dass** das Axialloch (2020, 2020') säulenförmig oder konusförmig ist.

4. Flüssigkeitsversorgungsmechanismus (20, 20') nach Anspruch 1, weiter **dadurch gekennzeichnet, dass** die untere Abdeckung (200) ein Verbindungsloch (2002) aufweist, die obere Abdeckung (202, 202') eine ringförmige Wand aufweist, die die Kammer (210) umgibt, und die ringförmige Wand mit dem Verbindungsloch (2002) fest verbunden ist.

5. Flüssigkeitsversorgungsmechanismus (20, 20') nach Anspruch 4, weiter **dadurch gekennzeichnet, dass** der Flüssigkeits-Auslass (2000) in dem Verbindungsloch (2002) vorgesehen ist.

6. Flüssigkeitsversorgungsmechanismus (20, 20') nach Anspruch 1, weiter **dadurch gekennzeichnet, dass** die Antriebseinheit (206) ein Federelement ist und abgewandte Enden der Antriebseinheit (206) gegen die obere Abdeckung (202, 202') und den Kolben (204) aufliegen.

7. Flüssigkeitsversorgungsmechanismus (30) nach Anspruch 1 weiter **dadurch gekennzeichnet, dass** die Antriebseinheit (306) einen ersten magnetischen Bereich (3060) und einen zweiten magnetischen Bereich (3062) umfasst, worin der erste magnetische Bereich (3060) auf der oberen Abdeckung (202) vorgesehen ist, der zweite magnetische Bereich (3062) auf dem Kolben (204) vorgesehen ist, eine Position des ersten magnetischen Bereichs (3060) einer Position des zweiten magnetischen Bereichs (3062) entspricht, und ein magnetischer Pol eines Endes des ersten magnetischen Bereich (3060), der dem zweiten magnetischen Bereich (3062) gegenüberliegt, identisch ist zu einem magnetischen Pol eines Endes des zweiten magnetischen Bereichs (3062), der dem ersten magnetischen Bereich (3060) gegenüberliegt, so dass eine magnetische Abstoßungskraft zwischen dem ersten magnetischen Bereich (3060) und dem zweiten magnetischen Bereich (3062) erzeugt wird.

8. Flüssigkeitsversorgungsmechanismus (30') nach Anspruch 1, weiter **dadurch gekennzeichnet, dass** die Antriebseinheit (306) einen ersten magnetischen Bereich (3060) und ein zweiten magnetischen Bereich (3062) umfasst, worin der erste magnetische Bereich (3060) auf der unteren Abdeckung (200) vorgesehen ist, worin der zweite magnetische Bereich (3062) auf dem Kolben (204) vorgesehen ist, eine Position des ersten magnetischen Bereichs (3060) einer Position des zweiten magnetischen Bereich (3062) entspricht, und ein magnetischer Pol eines Endes des ersten magnetischen Bereich (3060), der dem zweiten magnetischen Bereich (3062) gegenüberliegt, entgegengesetzt ist zu einem magnetischen Pol eines Endes des zweiten magnetischen Bereichs (3062), der dem ersten magnetischen Bereich (3060) gegenüberliegt, so dass eine magnetische Anziehungskraft zwischen dem ersten magnetischen Bereich (3060) und dem zweiten magnetischen Bereich (3062) erzeugt wird.

9. Flüssigkeitskühlsystem (1) **dadurch gekennzeichnet, dass** das Flüssigkeitskühlsystem (1) umfasst:
einen Flüssigkeits-Kühlkopf (10);
einen Kühler (12);
eine Pumpe (14);
einen Flüssigkeits-Lagerbehälter (16);
mehrere Röhren (18), die zwischen dem Flüssigkeits-Kühlkopf (10), dem Kühler (12), der Pumpe (14) und dem Flüssigkeits-Lagerbehälter (16) verbunden sind; und
den Flüssigkeitsversorgungsmechanismus (20, 20', 30, 30') nach Anspruch 1, der selektiv mit dem einem von dem Flüssigkeits-Kühlkopf (10), dem Kühler (12), der Pumpe (14), dem Flüssigkeits-Lagerbehälter (16) und den Röhren (18) verbunden ist.

## Revendications

1. Mécanisme d'alimentation en liquide (20, 20', 30, 30') comprenant :
un couvercle inférieur (200) ayant une sortie de liquide (2000) ;
un couvercle supérieur (202, 202') relié au couvercle inférieur (200), une chambre (210) étant formée entre le couvercle inférieur (200) et le couvercle supérieur (202, 202'), la chambre (210) communiquant avec la sortie liquide (2000), le couvercle supérieur (202, 202') ayant un trou axial (2020, 2020') ;
un piston (204) disposé de façon mobile dans la chambre (210), le piston (204) ayant une tige axiale (2040), la tige axiale (2040) étant insérée dans le trou axial (2020, 2020') ;
une unité d'entrainement (206, 306) disposée dans la chambre (210), l'unité d'entrainement (206, 306) entrainant le piston (204) à se déplacer ; et
**caractérisé en ce que** le mécanisme d'alimentation en liquide (20, 20', 30, 30') comprend en outre :
une pluralité d'éléments d'amortissement (208) disposés sur la tige axiale (2040), dans laquelle le nombre d'éléments d'amortissement attenant à la paroi interne du trou axial (2020, 2020') varie en réponse d'une hauteur du piston.

2. Mécanisme d'alimentation en liquide (20, 20', 30, 30') selon la revendication 1 **caractérisé en outre en ce que** l'élément d'amortissement (208) est un joint torique.

3. Mécanisme d'alimentation en liquide (20, 20', 30, 30') selon la revendication 1 **caractérisé en outre en ce que** le trou axial (2020, 2020') est en forme de pilier ou en forme de cône.

4. Mécanisme d'alimentation en liquide (20, 20') selon la revendication 1 caractérisé en outre en ce le couvercle inférieur (200) comporte un trou de liaison (2002), le couvercle supérieur (202, 202') comporte une paroi en forme d'anneau autour de la chambre (210), et la paroi en forme d'anneau est reliée au trou de liaison (2002) hermétiquement.

5. Mécanisme d'alimentation en liquide (20, 20') selon la revendication 4 **caractérisé en outre en ce que** la sortie du liquide (2000) est localisée dans le trou de liaison (2002).

6. Mécanisme d'alimentation en liquide (20, 20') selon la revendication 1 **caractérisé en outre en ce que** l'unité d'entrainement (206) est un élément élastique et des extrémités opposées de l'unité d'entrainement (206) qui viennent buter contre le couvercle supérieur (202, 202') et le piston (204).

7. Mécanisme d'alimentation en liquide (20, 20') selon la revendication 1 **caractérisé en outre en ce que** l'unité d'entrainement (206) comprend une première zone magnétique (3060) et une seconde zone magnétique (3062), la première zone magnétique (3060) est disposée sur le couvercle supérieur (202), la seconde zone magnétique (3062) est disposée sur le piston (204), une position de la première zone magnétique (3060) correspond à une position de la seconde zone magnétique (3062), et un pole magnétique d'une extrémité de la première zone magnétique (3060) en face de la seconde zone magnétique (3062) est identique à un pole magnétique d'une extrémité de la seconde zone magnétique (3062) en face de la première zone magnétique (3060), tel qu'une force répulsive magnétique est générée entre la première zone magnétique (3060) et la seconde zone magnétique (3062).

8. Mécanisme d'alimentation en liquide (30') selon la revendication 1 **caractérisé en outre en ce que** l'unité d'entrainement (306) comprend une première zone magnétique (3060) et une seconde zone magnétique (3062), la première zone magnétique (3060) est disposée sur le couvercle inférieur (200), la seconde zone magnétique (3062) est disposée sur le piston (204), une position de la première zone magnétique (3060) correspond à une position de la seconde zone magnétique (3062), et un pôle magnétique d'une extrémité de la première zone magnétique (3060) en face de la seconde zone magnétique (3062) est opposé à un pôle magnétique d'une extrémité de la seconde zone magnétique (3062) en face de la première zone magnétique (3060), tel qu'une force d'attraction magnétique est générée entre la première zone magnétique (3060) et la seconde zone magnétique (3062).

9. Système de refroidissement par liquide (1) **caractérisé par** le système de refroidissement par liquide (1) comprenant :
une tête de refroidissement par liquide (10) ;
un radiateur (12) ;
une pompe (14) ;
un réservoir de stockage du liquide (16) ;
une pluralité de tubes (18) connectés entre la tête de refroidissement (10), le radiateur (12), la pompe (14) et le réservoir de stockage du liquide (16) ; et le mécanisme d'alimentation en liquide (20, 20', 30, 30') selon la revendication 1 est sélectivement connecté à la tête de refroidissement par liquide (10), au radiateur (12), à la pompe (14), au réservoir de stockage du liquide (16) et aux tubes (18).
